# EUROPÄISCHE PATENTSCHRIFT

(11) **EP 1 579 513 B1**
(45) Veröffentlichungstag und Bekanntmachung des Hinweises auf die Patenterteilung: **16.01.2008**
(21) Anmeldenummer: 03775052.8
(22) Anmeldetag: 10.10.2003
(51) Int. Cl.: H01L 41/083

(54) **PIEZOAKTOR**
PIEZO ACTUATOR
ACTIONNEUR PIEZO-ELECTRIQUE

(30) Priorität: 23.12.2002 DE 10260854
(43) Veröffentlichungstag der Anmeldung: 28.09.2005
(73) Patentinhaber: ROBERT BOSCH GMBH, 70442 Stuttgart (DE)
(72) Erfinder: BOECKING, Friedrich, 70499 Stuttgart (DE); SCHOOR, Ulrich, 70439 Stuttgart (DE); SUGG, Bertram, 70839 Gerlingen (DE)
(86) Internationale Anmeldenummer: PCT/DE2003/003366
(87) Internationale Veröffentlichungsnummer: WO 2004/061987

(56) Entgegenhaltungen:
- WO-A-03/010835
- US-A- 5 252 883
- US-A1- 2002 152 857
- US-A1- 2002 153 431

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus zum Teil keramischem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Solche piezoelektrischen Aktoren eignen sich insbesondere für den Einsatz bei schnellen und präzisen Schaltvorgängen, beispielsweise bei verschiedenen Systemen der Benzin- oder Dieseleinspritzung in Injektoren für Verbrennungsmotoren.

Der Aufbau dieser Piezoaktoren kann hier in mehreren Schichten als sogenannte Multilayer-Piezoaktoren erfolgen, wobei die Innenelektroden, über die die elektrische Spannung aufgebracht wird, jeweils zwischen den Schichten angeordnet werden. Hierzu werden wechselseitig gestapelte Piezofolien mit aufgedruckten Elektrodenflächen als Innenelektroden, hergestellt. Dabei hat eine Folie ihren Anschluss jeweils nur auf einer Anschlussseite und auf der gegenüberliegenden Seite muss ein Rand ohne Innenelektrode mit einem Isolationsabstand verbleiben. Außen werden dann die beiden Seiten durch Außenelektroden verbunden. So entsteht in an sich bekannter Weise der Piezoaktor wie ein Kondensator mit vielen Platten.

Solche bekannten Multilayer-Piezoaktoren haben überwiegend rechteckige Innenelektroden, die an den gegenüberliegenden Seiten, an denen die Anschlusspotentiale an die Oberfläche geführt sind, in der Regel stark angefaste Ecken aufweisen. Hier können dann teilweise beide Innenelektrodenpotentiale an der Oberfläche nebeneinander, mit einer Keramikschicht dazwischen, zu liegen kommen. Diese Piezoaktoren werden allerdings mit Feldstärken betrieben, die eine Isolation der offenen Kriechstrecken auf der Keramik zwischen den Potentialen erforderlich machen. Geeignete Lacke oder Isolierstoffe mit guter Haftung und guten Durchschlags- und Isolationswerten können beispielsweise durch Sprühen oder Tauchen in üblicher Weise aufgebracht werden.

Die zuvor beschriebenen Piezoaktoren mit den wechselseitig nach außen geführten Innenelektroden neigen oft zu Ausfällen in Bereichen, wo die Innenelektroden relativ spitze Winkel aufweisen. Da die Kanten am Piezoaktor in der Regel an der mechanisch weichen Piezokeramik gebrochen werden müssen, entstehen die oben beschriebenen, in einem Winkel von 45°gefasten Ecken. Treten dort Innenelektroden nach außen, so tritt aus den oben genannten Gründen eine erhöhte Kurzschlussgefahr auf. Da sich die elektrische Feldstärke umgekehrt quadratisch proportional zum Krümmungsradius der Äquipotenzialfläche verhält, treten dort außerordentlich hohe Feldstärken auf, was dann dazu führt, dass die Piezoaktoren in diesem Bereich durch Kurzschluss ausfallen.

Weiterhin ist zu beachten, dass an den scharfen Kanten wegen physikalischer Effekte keine ausreichende Isolationsdicke aufgebaut wird, d.h. der eventuell aufgetragene Isolationslack zieht sich zurück. Also wird an den Stellen, an denen durch den Eckeneffekt der erhöhten Feldstärke eigentlich die beste Isolation erforderlich ist, die geringste Isolationsdicke erzielt. Zwar wäre es möglich, um eine etwas größere Isolationslackdicke auf den Kanten zu erhalten, den Lack relativ dick aufzubringen, jedoch kann dies auf den Flächen mit zu dickem Lack teilweise zu Lackrissen führen.

Aus der DE 199 28 191 A1 ist für sich gesehen ein Multilayer-Piezoaktor bekannt, bei dem jeweils die Piezolage, die keine zu kontaktierende Innenelektrode trägt, einen vorgegebenen Bereich nach innen versetzt ist.

US-A-5 252 883 offenbart einen Piezoaktor mit abgeschrägten oder abgerundeten Ecken.

### Vorteile der Erfindung

Der eingangs beschriebene Piezoaktor, der beispielsweise zur Betätigung eines mechanischen Bauteils verwendbar sein kann, ist mit einem Mehrschichtaufbau von Piezolagen und dazwischen angeordneten Innenelektroden aufgebaut. Erfindungsgemäß weisen in vorteilhafter Weise im Bereich der Ecken oder Kanten an den Seiten des hier gefasten Piezoaktors, an den mit wechselnder Polarität die Innenelektroden zu den jeweiligen Außenelektroden geführt sind, die Innenelektroden eine solche Kontur auf, dass eine verminderte Feldstärke zwischen den Innenelektroden unterschiedlicher Polarität im Aufbau der Piezolagen herstellbar ist.

Erfindungsgemäß werden auf einfache Weise die Fasen an der Ecke des Piezoaktors so gestaltet, dass die gesamte Ecke des Piezoaktors nur abgeschrägt und die Kontur der jeweils nicht kontaktierten Innenelektrode abgerundet ist.

Gemäß einer ersten vorteilhaften Ausführungsform sind die Fasen an der Ecke des Piezoaktors so gestaltet, dass die Kante an der Seite, die nicht mit Außenelektroden kontaktiert ist, einen stumpfen Winkel aufweist. Durch die Realisierung eines stumpfen oder flachen Winkels an der Seite des Kantenbruches, an dem wechselseitige Elektroden nach außen gehen, können auf einfache Weise Feldspitzen am Piezoaktor in Bereichen von nach außen tretenden, sich über die Piezolage jedoch gegenüberliegenden Innenelektroden, vermieden werden. Damit wird das Risiko eines Kurzschlusses drastisch reduziert und somit die Zuverlässigkeit der Piezoaktoren erhöht.

Realisiert werden kann der stumpfe Winkel zum einen, indem die Elektrodenfläche durch die Außenkontur des Piezoaktors angepasst wird. Dies geschieht über die Formgebung im sogenannten Grünzustand des Piezoaktors vor dem Sintern oder durch eine Hartbearbeitung nach dem Sintern. Eine weitere Möglichkeit besteht darin, über das Druckbild bei der Herstellung der Innenelektrode bereits einen stumpfen Winkel zu realisieren.

Nach einer zweiten vorteilhaften Ausführungsform sind die Fasen an der Ecke des Piezoaktors so gestaltet, dass zumindest die Kante an der Seite, die nicht mit Außenelektroden kontaktiert ist, abgerundet ist. Hierbei ist es auch vorteilhaft möglich, wenn die Fasen an der Ecke des Piezoaktors so gestaltet sind, dass die gesamte Ecke des Piezoaktors und korrespondierend dazu die Kontur der jeweils nicht kontaktierten Innenelektrode abgerundet ist.

Gemäß einer nicht erfindungsgemäßen Ausgestaltung ist die Kontur der jeweils nicht kontaktierten Innenelektrode an der Seite der Kontaktierung der Innenelektrode der jeweils anderen Polarität so gestaltet ist, dass sie einen vorgebebenen Betrag von der Außenkontur des Piezoaktors zurückversetzt ist. Hierbei kann die Kontur der jeweils nicht kontaktierten Innenelektrode korrespondierend zur Außenkontur des Piezoaktors zurückversetzt sein.

Es kann so auf einfache Weise sichergestellt werden, dass ausreichend Isoliermaterial zwischen der nicht kontaktierten Innenelektrode und der Oberfläche des Piezoaktors und somit letztlich zwischen den beiden Elektrodenpotenzialen, verbleibt. Die hohen Feldstärken führen nicht frühzeitig zum einem Durchschlagschaden, wobei die zusätzliche überdeckende und isolierende Keramikschicht hierbei ein Ersatz für eine ev. zu dünn ausfallende Lackschichten auf der Oberfläche ist.

Gemäß der Erfindung führen Beschädigungen und leichte Scheuerspuren an der Kante nicht mehr zwangsläufig zu Überschlägen und die Lackdicke auf der Oberfläche kann insgesamt reduziert werden und ist damit kaum noch rissgefährdet und macht Aktordehnungen leichter mit, ohne auf Dauer zu reißen. Außerdem haftet der Lack insgesamt besser an den erfindungsgemäß gestalteten Ecken und Kanten als an relativ scharfen Kanten.

### Zeichnung

Ausführungsbeispiele des erfindungsgemäßen Piezoaktors werden anhand der Zeichnung erläutert. Es zeigen:
Figur 1 einen Schnitt durch einen Piezoaktor mit einem Mehrschichtaufbau von Lagen aus Piezokeramik und Elektroden nach dem Stand der Technik,
Figuren 2 und 3 jeweils Piezolagen mit Innenelektroden wechselnder Polarität mit angefasten Ecken,
Figur 4 ein nicht erfindungemäßes Ausführungsbeispiel eines Elektrodendesigns mit einem stumpfen Winkel im Bereich sich überdeckender Innenelektroden,
Figuren 5 und 5a ein zweites nicht erfindungemäßes Ausführungsbeispiel eines Elektrodendesigns mit abgerundeten Kanten und
Figuren 6 ein erfindungemäßes Ausführungsbeispiel eines Elektrodendesigns mit nach innen versetzten abgerundeten Kanten.

### Beschreibung der Ausführungsbeispiele

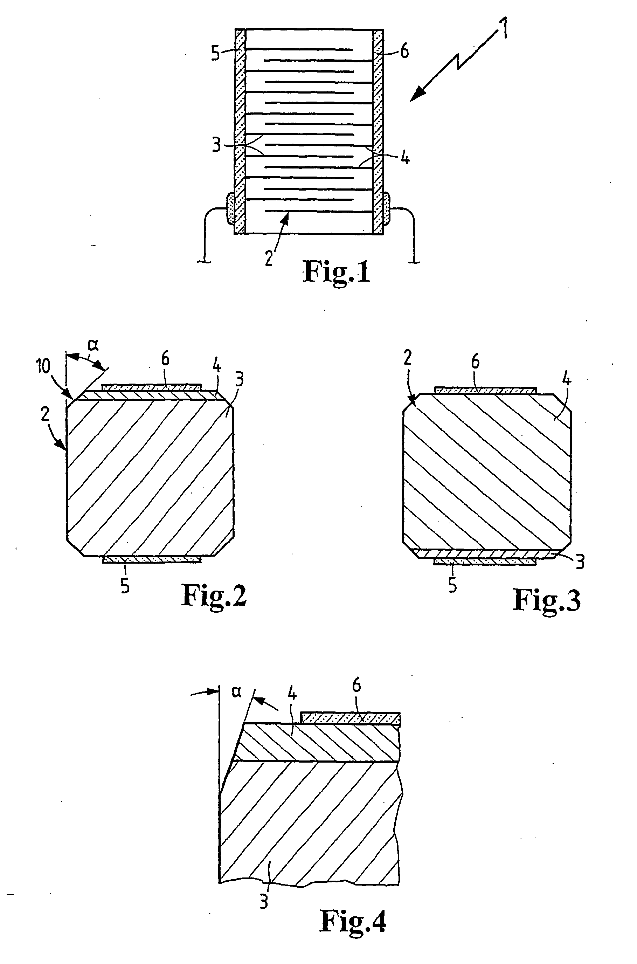

In Figur 1 ist ein Piezoaktor 1 im Prinzip nach dem Stand der Technik gezeigt, der in an sich bekannter Weise aus Piezolagen bzw. Piezofolien 2 eines Quarzmaterials mit einer geeigneten Kristallstruktur aufgebaut ist, so dass unter Ausnutzung des sogenannten Piezoeffekts bei Anlage einer äußeren elektrischen Spannung an Innenelektroden 3 und 4 über Kontaktflächen bzw. Außenelektroden 5 und 6 eine mechanische Reaktion des Piezoaktors 1 erfolgt.

In Figur 2 ist eine angefaste Piezolage 2 gezeigt, mit der Innenelektrode 3, die mit der Außenelektrode 5 kontaktiert ist. Im Bereich der Kontaktierung der anderen Innenelektrode 4, die aus Figur 3 erkennbar ist, wird auf der linken Seite des Piezoaktors 1 nach der Figur 2 ein Winkel α der angefasten Ecke mit der Kante 10 verdeutlicht. Da, wie in der Beschreibungseinleitung bereits erwähnt, die Kanten am Piezoaktor 1 üblicherweise in einem Winkel von 45°gefast sind, tritt dort an der Ecke 10 eine erhöhte Kurzschlussgefahr auf.

Die nicht erfindungsgemäße Piezolage nach Figur 4 weist im Unterschied zur Darstellung nach der Figur 3 einen stumpfen Winkel mit dem Komplementwinkel α < 45° auf, so dass hier Feldspitzen am Piezoaktor 1 in Bereichen von nach außen tretenden, sich über die Piezolagen 2 jedoch gegenüberliegenden Innenelektroden 3 und 4 vermieden werden.

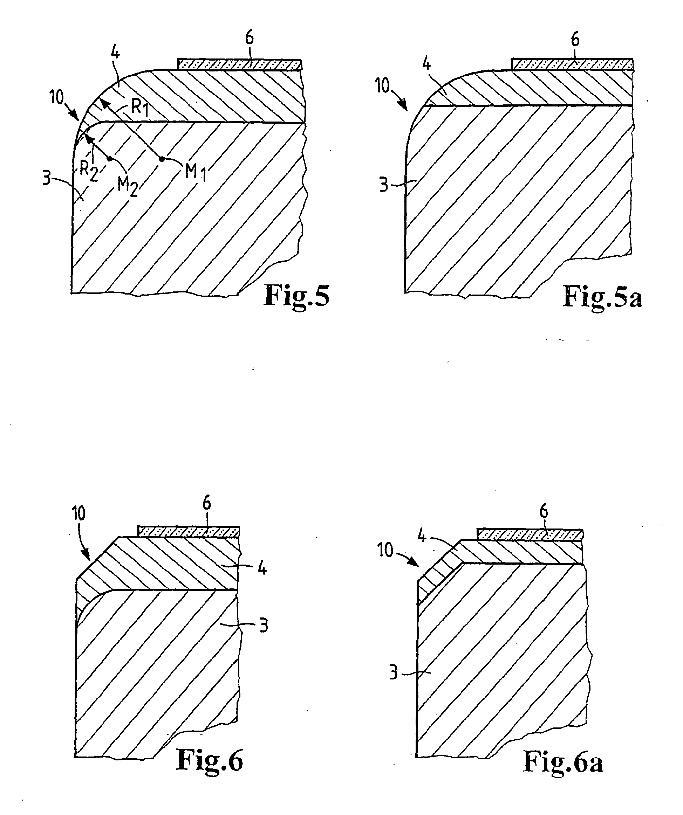

Das Elektrodendesign nach Figur 5 und 5a besteht darin, dass die Innenelektrode 3 derart ausgestaltet ist, dass sie tangential zur Außenfläche des Piezoaktors 1 mündet. Die Innenelektrode 3 ist hier um einen Mittelpunkt M2 mit dem Radius R2 gekrümmt. Dabei kann die Außenkontur des Piezoaktors 1 ebenfalls gekrümmt sein und nach der Figur 5a kann die Innenelektrode 3 auch mit der Außenkontur gekrümmt sein. Beispielhaft ist dies in der Figur 5 durch eine Krümmung mit dem Mittelpunkt M1 und dem Radius R1 dargestellt.

Bei einer erfindungsgemäßen Piezolage nach Figur 6 kann die äußere Kontur der Innenelektroden 3 und 4 auch geradflächig ausgeformt sein und die hier nicht kontaktierte Innenelektrode 3 nach der Figur 6 kann gemäß Figur 6a auch korrespondierend nach innen versetzt sein.

## Patentansprüche

1. Piezoaktor, mit
- einem Mehrschichtaufbau von Piezolagen (2) und dazwischen angeordneten Innenelektroden (3,4), mit
- einer wechselseitigen Kontaktierung der Innenelektroden (3,4) mit Außenelektroden (5,6) und mit gefasten Ecken (10) am Piezoaktor (1), **dadurch gekennzeichnet, dass**
- die Fasen an der Ecke des Piezoaktors so gestaltet sind, dass die gesamte Ecke des Piezoaktors abgeschrägt und die Kontur der jeweils nicht kontaktierten Innenelektrode (3, 4) abgerundet ist,
- so dass eine gegenüber gleichartig konturierten Innenelektroden (3, 4) verminderte Feldstärke zwischen den Innenelektroden (3,4) unterschiedlicher Polarität im Aufbau der Piezolagen (2) hergestellt wird.

2. Piezoaktor nach Anspruch 1, **dadurch gekennzeichnet, dass**
- die Fasen an der Ecke des Piezoaktors (1) so gestaltet sind, dass die Kante (10) an der Seite, die nicht mit Außenelektroden (5,6) kontaktiert ist, einen derart großen stumpfen Winkel aufweist, dass für den dazugehörige äußeren Komplementwinkel (α) am Piezoaktor (1) α < 45° gilt.

## Claims

1. Piezo actuator, with
- a multilayer structure of piezo layers (2) and inner electrodes (3, 4) arranged in between, with
- alternating contacting of the inner electrodes (3, 4) with outer electrodes (5, 6) and with chamfered corners (10) on the piezo actuator (1), **characterized in that**
- the chamfers at the corner of the piezo actuator are shaped in such a way that the entire corner of the piezo actuator is bevelled and the contour of the inner electrode (3, 4) that is respectively not contacted is rounded,
- so that a field strength that is reduced in comparison with similarly contoured inner electrodes (3, 4) is established between the inner electrodes (3, 4) of different polarity in the structure of the piezo layers (2).

2. Piezo actuator according to Claim 1, **characterized in that**
- the chamfers at the corner of the piezo actuator (1) are shaped in such a way that the edge (10) on the side that is not contacted with outer electrodes (5, 6) has such a large obtuse angle that α < 45° for the associated outer complementary angle (α) at the piezo actuator (1).

## Revendications

1. Actionneur piézo-électrique comprenant :
- une structure à plusieurs couches piézo-électriques (2) avec interposition d'électrodes internes (3, 4),
- une mise en contact sur une alternance de côté des électrodes intérieures (3, 4) avec les électrodes extérieures (5, 6) et les coins tronqués (10) de l'actionneur piézo-électrique (1),
**caractérisé en ce que**
les congés des coins de l'actionneur piézo-électrique sont conçus pour que l'ensemble du coin de l'actionneur piézo-électrique soit en biais et que le contour des électrodes intérieures (3, 4) chaque fois non mises en contact, soit arrondi,
pour développer ainsi une intensité de champ réduite par rapport aux électrodes internes (3, 4) à contour de même type, entre les électrodes internes (3, 4) de polarité différente dans la structure des couches piézo-électriques (2).

2. Actionneur piézo-électrique selon la revendication 1,
**caractérisé en ce que**
les congés des coins de l'actionneur piézo-électrique (1) sont conçus pour que l'arête (10) du côté non en contact avec les électrodes extérieures (5, 6) présente un angle obtus suffisamment grand pour que l'angle complémentaire extérieur (α) correspondant sur l'actionneur piézo-électrique (1) soit tel que α < 45°.
